(19) Europäisches Patentamt
European Patent Office
Office européen des brevets

(11) **EP 1 221 634 A2**

(12) **EUROPÄISCHE PATENTANMELDUNG**

(43) Veröffentlichungstag:
**10.07.2002 Patentblatt 2002/28**

(51) Int Cl.⁷: **G03F 7/20**

(21) Anmeldenummer: **01127095.6**

(22) Anmeldetag: **15.11.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **08.01.2001 DE 10100265**

(71) Anmelder: **CARL ZEISS SEMICONDUCTOR MANUFACTURING TECHNOLOGIES AG**
**73447 Oberkochen (DE)**

(72) Erfinder:
• **Singer, Wolfgang, Dr.**
**73431 Aalen (DE)**
• **Ulrich, Wilhelm**
**73434 Aalen (DE)**
• **Antoni, Martin**
**73434 Aalen (DE)**

(74) Vertreter: **Sawodny, Michael-Wolfgang**
**Dr. Weitzel & Partner,**
**Friedenstrasse 10**
**89522 Heidenheim (DE)**

(54) **Beleuchtungssystem mit Rasterelementen unterschiedlicher Grösse**

(57) Die Erfindung umfaßt ein Beleuchtungssystem, insbesondere für die Lithographie mit Wellenlängen ≤ 193 nm umfassend

- eine Lichtquelle
- ein erstes optisches Element, das in erste Rasterelemente gegliedert ist und in einer ersten Ebene liegt, die durch eine x-Richtung und eine y-Richtung aufgespannt wird, wobei
- durch die ersten Rasterelemente sekundäre Lichtquellen erzeugt werden und
- die ersten Rasterelemente jeweils eine x- und eine y-Ausdehnung mit einem Seitenaspektverhältnis aufweisen.

Die Erfindung ist dadurch gekennzeichnet, daß

- zumindest zwei Rasterelemente ein unterschiedlich großes Seitenaspektverhältnis aufweisen.

Fig.2

EP 1 221 634 A2

**Beschreibung**

Die Erfindung betrifft ein Beleuchtungssystem, insbesondere ein solches für die Lithographie also beispielsweise VUV und EUV-Lithographie mit Wellenlängen kleiner gleich 193 nm, welches ein Feld beleuchtet, wobei das Beleuchtungssystem wenigstens eine Lichtquelle sowie optische Elemente, die in Rasterelemente gegliedert sind, umfaßt.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern.

Denkbar ist bei Wellenlängen kleiner als 193 nm beispielsweise die Lithographie mit weichen Röntgenstrahlen. Ein doppelt facettiertes Beleuchtungssystem für derartige Wellenlängen ist beispielsweise aus der DE 199 03 807 bekanntgeworden. Der Offenbarungsgehalt der DE 199 03 807 wird in die vorliegende Anmeldung vollumfänglich mitaufgenommen.

Bei dem aus der DE 199 03 807 bekannten Beleuchtungssystem werden die ersten Rasterelemente, die auch als Feldwaben bezeichnet werden, über eine Kollektionsoptik ausgeleuchtet. Bei Anordnung in Reflexion erfolgt die Ausleuchtung unter einem bestimmten Einfallswinkel. Daher ist das ausgeleuchtete Feld auf den Feldwaben ist vorzugsweise elliptisch. Die Feldwaben sind entsprechend dem gewünschten Feld in der Objektebene, die mit der Retikelebene zusammenfällt jedoch rechteckig gestaltet.

Jede Feldwabe wird in ein Feld in eine Objektebene, in der das Retikel zu liegen kommt, abgebildet. Da jede Feldwabe zur Uniformität der ausgeleuchteten Fläche beiträgt, beeinflussen nur teilweise ausgeleuchtete Feldwaben die Uniformität in der Objektebene negativ. Es dürfen daher nur vollständig ausgeleuchtete Feldwaben eingesetzt werden.

Bei Systemen, wie sie aus der DE 199 03 807 bekannt sind, weisen die ersten Rasterelemente bzw. Facetten ein typisches Aspektverhältnis von ∼ 1:16 auf. Bei derartigen Systemen wird nur eine Flächenüberdeckung von etwa 80 % erreicht, d.h. etwa 20 % der Leistung gehen verloren. Da die Zahl der Feldwaben durch das nachfolgende Beleuchtungssystem und aus Gründen der Geometrie und Baubarkeit begrenzt ist, kann man nicht einfach durch Vergrößerung der Anzahl der Feldwaben eine bessere Effizienz eines Beleuchtungssystems wie aus der DE 199 03 807 bekannt, erreichen.

Aufgabe der Erfindung ist es daher, ein Beleuchtungssystem anzugeben, das die Nachteile des Standes der Technik überwindet, insbesondere eine hohe Ausnutzung der eingestrahlten Lichtleistung aufweist.

Erfindungsgemäß wird die Aufgabe durch ein Beleuchtungssystem gemäß Anspruch 1 gelöst.

Erfindungsgemäß werden zur Minimierung dieser Verluste die ersten Rasterelemente, die auch als Feldwaben bezeichnet werden, mit unterschiedlicher Form ausgestaltet. Beispielsweise können sie unterschiedlich groß sein oder das Aspektverhältnis der einzelnen Feldwaben kann über den Feldwabenspiegel variieren, so daß sich eine bessere Überdeckung und damit eine höhere Effizienz ergibt.

Um die unterschiedlichen Größen bzw. Aspektverhältnisse der ersten Rasterelemente bzw. Feldwaben auszugleichen, werden die zweiten Rasterelemente bzw. Pupillenwaben anamorphotisch ausgelegt. Der Anamorphismus bzw. die astigmatische Wirkung der jeweiligen Pupillenwabe ist hierfür an das Aspektverhältnis der jeweiligen Feldwaben angepaßt.

Das wesentliche Kennzeichen der Erfindung ist somit, daß Pupillenwaben unterschiedlicher anamorphotischer Wirkung in Verbindung mit Feldwaben mit unterschiedlichen Aspektverhältnissen zu einer höheren Energieausnutzung der Lichtquelle durch das Beleuchtungssystem führen. Dies erreicht man dadurch, daß die zweiten Rasterelemente unterscheidliche anamorphotische Wirkung aufweisen, so daß unabhängig vom Aspektverhältnis der ersten Rasterelemente das Aspektverhältnis der Bilder der ersten Rasterelemente in der Objektebene des Beleuchtungssystems, in der beispielsweise ein Retikel zu liegen kommt, im wesentlichen dem Feldaspektverhältnis entspricht. Die Feldwaben können, müssen aber keine anamorphotische Wirkung aufweisen.

Eine anamorphotische Wirkung kann im einfachsten Fall durch eine torische Flächenform realisiert werden, d.h. die Krümmungsradien eines in x- und y-Richtung ausgedehnten Spiegels unterscheiden sich in y- und in x-Richtung im Scheitelpunkt eines Spiegels, d.h. $R_y$ ungleich $R_x$.

Weitere vorteilhafte Ausgestaltungen der Erfindung sind Gegenstand der Unteransprüche.

Die Erfindung soll nachfolgend anhand der Zeichnungen beispielhaft beschrieben werden.

Es zeigen:

Figur 1    Feldwabenplatte mit vielen identischen Feldwaben, die entweder isotrop oder anamorphotisch ausgebildet sein können.

Figur 2    Ausgestaltung eine Feldwabenplatte gemäß der Erfindung mit Feldwaben mit unterschiedlichem Aspektverhältnis. Zur besseren Anordnung sind alle Feldwaben einer Zeile jeweils gleich hoch, nur die Breite wurde geändert.

Figur 3    Prinzipskizze zur Herleitung der Formeln für isotrope Feld- und Pupillenwaben

Figur 4    Prinzipskizze zur Herleitung des Abbildungsmaßstabes bei anamorphotischen Pupillenwaben, wobei die Feldwaben als stärker fokussierende Feldwaben ausgebildet sind.

Figur 5    Prinzipskizze zur Herleitung des Abbildungsmaßstabes bei anamorphotischen Pupillenwaben, wobei die Feldwaben als schwächer fokussierende Feldwaben ausgestaltet sind.

Figur 6    Prinzipskizze eines Beleuchtungssystems.

Figur 7    Prinzipskizze eines Projektionsbelichtungssystems.

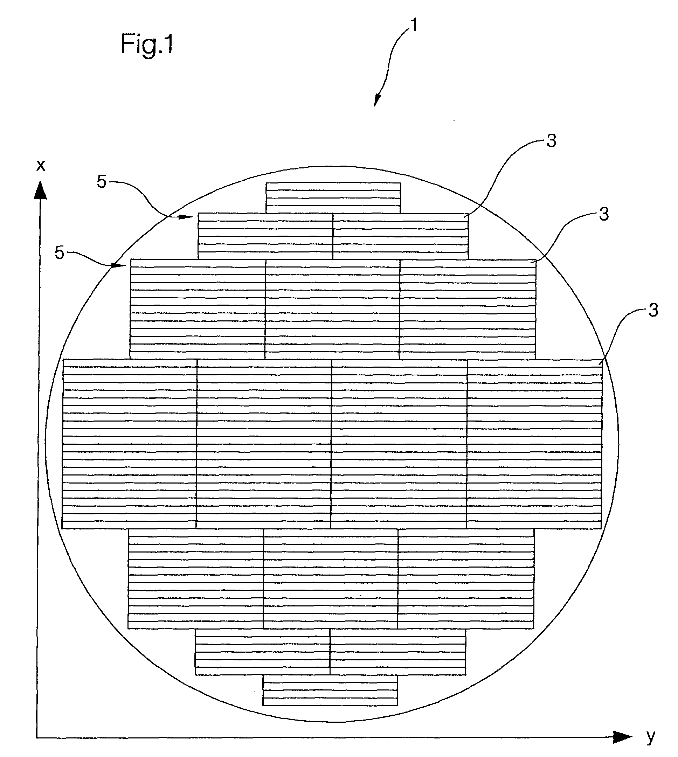

Figur 1 zeigt eine herkömmliche Gestaltung einer Feldwabenplatte 1 mit Feldwaben 3 identischer Größe, wie sie aus der DE 199 03 807 bekanntgeworden ist. Die Feldwaben 3 weisen ein typisches Aspektverhältnis von $\sim$ 1:16 auf. Auf der leicht elliptisch ausgeleuchteten Fläche sind etwa 200 Feldwaben 3 angeordnet. Es wird eine Flächenüberdeckung von etwa 80 % erreicht, d.h. etwa 20 % der Leistung gehen verloren.

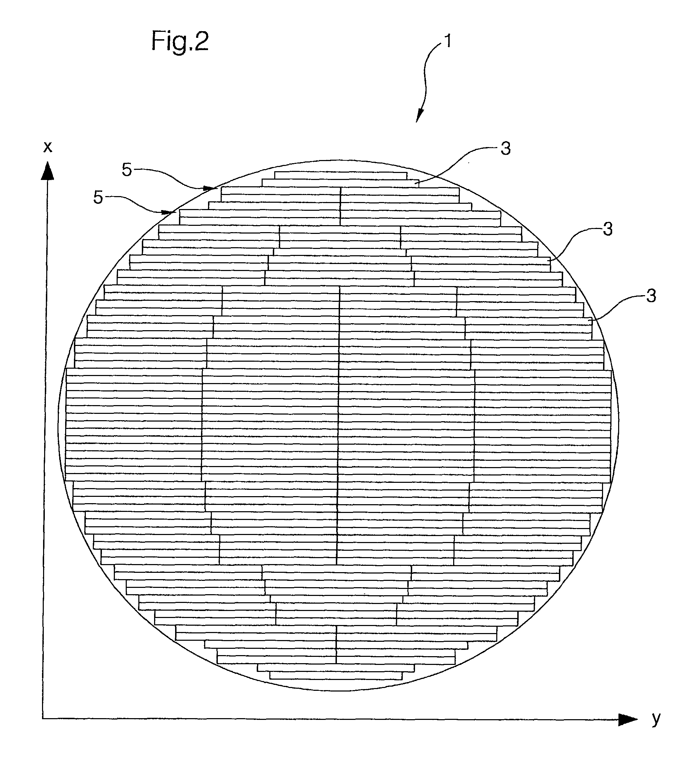

Um diesen Verlust zu minimieren, weisen erfindungsgemäß die Feldwaben ,wie in Figur 2 gezeigt, unterschiedliche Form auf. Dadurch können die Feldwaben 3 unterschiedlich groß gestaltet werden, ferner kann das Aspektverhältnis der einzelnen Feldwaben 3 über den Feldwabenspiegel 1 variieren, so daß sich eine bessere Überdeckung und damit eine höhere Effizienz ergibt.

Eine so gestalteten Feldwabenplatte 1 ist in Figur 2 dargestellt; hierzu wurden die Feldwaben 3 der in Figur 1 gezeigten Feldwabenplatte 1 so umgestaltet, daß sich eine bessere Überdeckung ergibt. Die Effizienz kann dabei auf über 95 % gesteigert werden. Die Anzahl der Feldwaben wurde dabei gleichzeitig geringfügig vergrößert, was zwar nicht erforderlich, jedoch hilfreich ist. Die Feldwaben sind in Zeilen 5 angeordnet.

Zur besseren Anordnung sind alle Feldwaben einer Zeile 5 bei der Ausführungsform gemäß Figur 2 jeweils gleich hoch, nur die Breite wurde geändert. Die x-Richtung verläuft nach oben, die y-Richtung nach rechts.

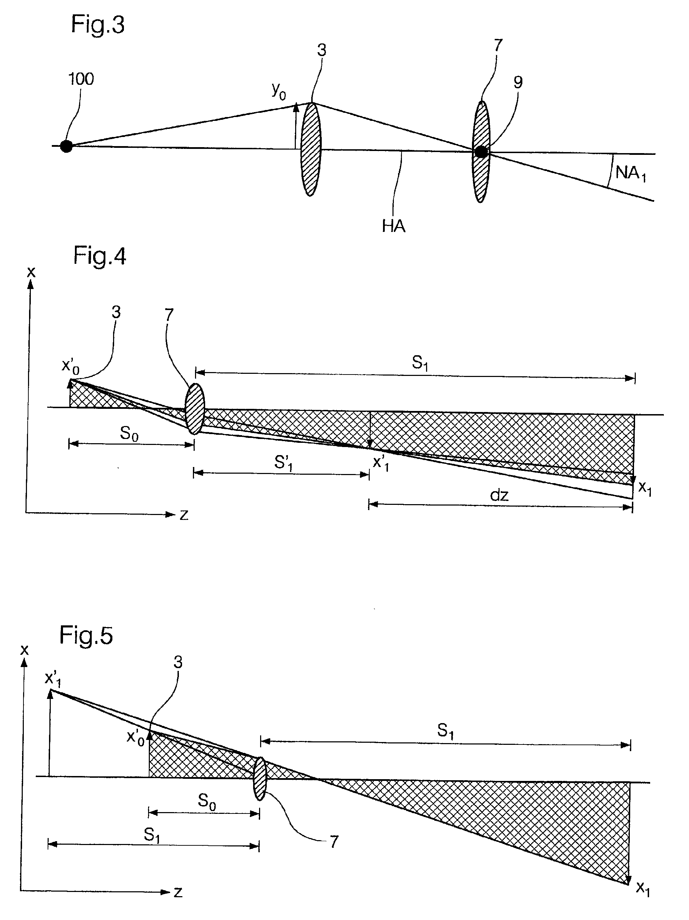

Die folgende Ableitung anhand von Figur 3 gibt in Abhängigkeit der unterschiedlichen Breiten der Feldwaben die unterschiedlichen Brechkräfte durch eine Berechnung nach geometrisch-optischen Formeln.

Zunächst soll der Fall eines Kanales zwischen einer Feld- 3 und einer Pupillenwabe 7 betrachtet werden, wobei die Feldwabe 3 isotrop ist, ebenso wie die Pupillenwabe 7. Für diesen Fall einer isotropen Feldwabe 3 und exakter Köhlerschen Beleuchtung ist die Größe der Feldwabe 3 mit der Apertur $NA_1$ hinter der Pupillenwabe 7 respektive dem doppelt facettierten System verknüpft über:

$$(1) \qquad NA_1 = \frac{y_0}{Z}$$

wobei

$y_0$:    Höhe der Feldwabe (halber Durchmesser in y-Richtung)
$Z$:    Distanz zwischen Feld- und Pupillenwabe

Desweiteren liegt das Lichtquellenbild 9, welches die Feldwabe 3 erzeugt, in der Pupillenwabe 7, d.h. der Schnittpunkt von Aperturstrahl und optischer Achse HA liegt in der Pupillenwabe 7. Für die Brechkraft der Feldwabe folgt in diesem Fall

$$(2) \qquad \frac{1}{f_y^{fw}} = \frac{1}{Z} + \frac{1}{D}$$

wobei

$D$ :    Distanz zwischen Lichtquelle und Feldwabe
$f_y^{fw}$ :    Brennweite der Feldwabe in y-Richtung

Nimmt man Werte an, welche typisch für ein EUV-Beleuchtungssystem sind:

D = 1200 mm

Z = 900 mm

$\beta$ = - 3,5:

typischer Abbildungsmaßstab für die Pupillenwabe

$S_1$ = 3150 mm:

bildseitge Schnittweite des Bildes der Feldwabe, $S_1$ = -Z·$\beta$

$2x_0$ x $2y_0$ = 2.8 mm x 46 mm :

Größe der Feldwabe

so ergeben sich folgende Designwerte für isotrope Feld- bzw. Pupillenwaben:

Brennweite der Feldwabe:

$f^{fw}$ = 514.286 mm

Brennweite der Pupillenwabe:

$f^{pw}$ = 700 mm

Krümmungsradius der Feldwabe bei reflektiver Auslegung:

$R^{fw}$ = -2$f^{fw}$ = -1028.571 mm

Krümmungsradius der Pupillenwabe bei reflektiver Auslegung:

$R^{pw}$ = -1400 mm

Falls man alle Feldwaben 3 wie in Figur 2 gezeigt, in x-Richtung gleich läßt, und das Aspektverhältnis der Feldwaben 3 nur über die Breite in y ändert, so kann man in x-Richtung durchgehend Gleichung (1) anwenden. Es gelten dann die Werte aus dem vorangegangenen Abschnitt für die x-Richtung. Für die y-Richtung ist es notwendig, die Brechkraft der Pupillenwaben zu ändern.

Ändert man die Brechkraft der Pupillenwabe 7, so ändert man auch den Abbildungsmaßstab. Damit ändert man auch die bildseitige Schnittweite $S_1$ in $S'_1$, wobei die objektseitige Schnittweite - Abstand zwischen Feld- und Pupillenwabe ja gleich bleibt: $S_0$ = -Z.

Die Bildebene mit Schnittweite $S_1$ wird durch die nachfolgende Abbildungsoptik des Beleuchtungssystems in die auszuleuchtende Objektebene abgebildet. Entsteht das Bild der Feldwabe in einer anderen Ebene, wird das Abbild in der auszuleuchtenden Objektebene, die mit der Retikelebene zusammenfällt, verwaschen. Dies muß also bei der Auslegung des Abbildungsmaßstabes der Pupillenwabe berücksichtigt werden, damit nicht unnötig viel Licht verloren geht. Wie in Figur 4 dargestellt, verbreitert sich also die ausgeleuchtete Fläche in der zur Objektebene konjugierten Ebene $S_1$ mit

$$(3) \qquad \Delta y' = (S_1 - S'_1) \cdot \tan(\arcsin(p_1)) = dz \cdot \tan(\arcsin(p_1)) \approx dz \cdot p_1$$

wobei

$\Delta y'$:          halbe Verbreiterung der ausgeleuchteten Länge in Ebene $S_1$

dz = $S_1$ - $S'_1$ :    Distanz zwischen den Bildebenen

$p_1$:          optischer Richtungskosinus des maximalen Öffnungsstrahls für den Abbildungsstrahlengang mit einer punktförmigen Lichtquelle

Ferner verbreitert sich die Ausleuchtung bei endlicher Quellgröße um die Apertur der sekundären Lichtquelle in der Objektebene. Üblicherweise ist diese Apertur und die dadurch erzeugte zusätzliche Verbreiterung jedoch vernachlässigbar klein. Diese geringe Verbreiterung durch die endliche Quellgröße wird in der folgenden Ableitung vernachlässigt.

$$(4) \qquad \beta y_0 \approx \beta' y'_0 + dz' \cdot p_1$$

$\beta$ : Abbildungsmaßstab der Abbildung durch die konventionelle Pupillenwabe mit normaler Feldwabe

$\beta'$ : Abbildungsmaßstab der anamorphotischen Pupillenwabe in y-Richtung

$y_0$ : Feldwabenhöhe bei konventioneller Auslegung

$y_0'$ : Feldwabenhöhe mit geändertem Aspektverhältnis

$dz'$ : longitudinaler Bildversatz in der Bildebene hinter der Pupillenwabe

$p_1$ : optischer Richtungskosinus im Bildraum der Pupillenwabe (y-Komponente); entspricht Apertur hinter dem Wabenkondensor

Setzt man für $p_1$ die wohlbekannte Abbildungsgleichung erster Ordnung ein:

$$(5) \qquad p_1 = - \frac{1}{f_y} \, y'_0 + \frac{1}{\beta'} \, p'_0$$

wobei

$p'_0$ : optischer Richtungskosinus im Objektraum der Pupillenwabe (y-Komponente)

$f_y$ : Brennweite der Pupillenwabe in y-Richtung

so erhält man nach Umformung und Einsetzen der Schnittweiten mit $\beta' = S'_1/S_0$, $\beta = S_1/S_0$ und $dz = S_1 - S'_1$:

$$(6) \qquad S'_1 = \frac{S_1 \, S_0 \, (y'_0 - S_0 \, p'_0)}{S_0 \, (y'_0 - S_0 p'_0) + S_1 \, (y'_0 - y_0)}$$

Man muß nun noch $p'_0$ wählen, d.h. die sammelnde Wirkung der Feldwaben 3 bestimmen.

Hierzu setzt man verallgemeinerte Gleichungen (1) und (2) ein und erhält aus

$$(7)$$

$$p_0 = - y'_0 \left( \frac{1}{f_y^{fw}} - \frac{1}{D} \right)$$

wobei

$y'_0$ : Höhe der Feldwaben mit geändertem Aspektverhältnis

$f_y^{fw}$ : Brennweite der Feldwaben in y-Richtung

$D$ : Distanz zwischen Lichtquelle und Feldwaben

Wählt man folgende Parameter, die dem typischen Design-Beispiel von oben entnommen sind, wobei ferner gilt:

$y_0$ = 23 mm:

halber Durchmesser der "normalen" nicht anamorphotischen Feldwabe in y-Richtung

M = 10 mm:

Durchmesser der Pupillenwabe

Wählt man ferner als Wabengröße für die Feldwaben mit geändertem Aspektverhältnis

$y_0' = 26$ mm:

halber Durchmesser der Feldwaben mit geändertem Aspektverhältnis in y-Richtung

so hat man drei prinzipielle Möglichkeiten der Realisierung. Es werden dabei jeweils nur die Brennweiten angegeben; die entsprechenden Krümmungsradien $R_x$ und $R_y$ in x- und y-Richtung der anamorphotischen Spiegel sind jeweils durch $-2f_x$ bzw. $-2f_y$ gegeben.

In einer ersten Ausführungsform gemäß Figur 4 werden stärker sammelnde Feldwaben 3 eingesetzt. Damit das Strahlenbüschel hinter der Feldwabe 3 durch die Pupillenwabe 7 endlicher Ausdehnung nicht vignettiert wird, muß gelten

$$(8) \qquad P'_0 > \frac{|y'_0| + \frac{M}{2}}{S_0}$$

hier also $p'_0 > -0.034$. Mit $p'_0 = -0.033$ erhält man aus Gleichung (6) und Gleichung (7) folgende Werte für die Brennweiten:

Brennweite in y-Richtung der Feldwabe mit Höhe 26 mm:

$f_y^{fw} = 475.61$ mm

Brennweite in y-Richtung der zugeordneten Pupillenwabe:

$f_y = 429.28$ mm

Brennweite in x-Richtung der Feldwabe mit Höhe 1.4 mm:

$f_x^{fw} = 514.286$ mm

Brennweite in x-Richtung der zugeordneten Pupillenwabe:

$f_x^{pw} = 700$ mm

In einer zweiten Ausführungsform gemäß Figur 5 werden anamorphotisch schwächer fokussierende Feldwaben verwandt.

Damit das Strahlenbüschel hinter der Feldwabe 3 durch die Pupillenwabe 7 endlicher Ausdehnung nicht vignettiert wird, muß nun gelten

$$(9) \qquad P'_0 > \frac{|y'_0| + \frac{M}{2}}{S_0}$$

hier also $p'_0 < -0.0233$. Mit $p'_0 = -0.024$ erhält man aus Gleichung (6) und Gleichung (7) folgende Werte für die Brennweiten:

Brennweite in y-Richtung der Feldwabe mit Höhe 26 mm:

$f_y^{fw} = 569.34$ mm

Brennweite in y-Richtung der zugeordneten Pupillenwabe:

$$f_y = 1490.32 \text{ mm}$$

Brennweite in x-Richtung der Feldwabe mit Höhe 1.4 mm:

$$f_x^{fw} = 514.286 \text{ mm}$$

Brennweite in x-Richtung der zugeordneten Pupillenwabe:

$$f_x^{pw} = 700 \text{ mm}$$

Aus Fertigungsgründen ist es bevorzugt, die Feldfacetten 3 isotrop, i.e. sphärisch zu krümmen, und nur die Pupillenwaben 7 mit anamorphotischer Wirkung zu gestalten, um die unterschiedlichen Aspektverhältnisse auszugleichen. Feldwaben 3 mit verschiedenen Aspektverhältnissen können dann beispielsweise wie folgt ausgelegt werden:

Brennweite Feldwabe mit Ausdehnung 2.8 mm x 46 mm:

$$f_x^{fw} = f_y^{fw} = 475.61 \text{ mm}$$

Brennweite in y-Richtung der zugeordneten Pupillenwabe:

$$f_y = 429.28 \text{ mm}$$

Brennweite in x-Richtung der zugeordneten Pupillenwabe:

$$f_x^{pw} = 700 \text{ mm}$$

Für eine weitere Feldwaben mit einer Höhe $y_0'' = 20$ mm, die also schmäler ist und ein geringeres Aspektverhältnis aufweist, ergibt sich beispielsweise

Brennweite Feldwabe mit Ausdehnung 2.8 mm x 40 mm:

$$f_x^{fw} = f_y^{fw} = 402.68 \text{ mm}$$

Brennweite in y-Richtung der zugeordneten Pupillenwabe:

$$f_y = 921.72 \text{ mm}$$

Brennweite in x-Richtung der zugeordneten Pupillenwabe:

$$f_x^{pw} = 700 \text{ mm}$$

und natürlich für die ursprüngliche Feldwabe mit der Höhe 23 mm:

Brennweite der Feldwabe:

$$f^{fw} = 514.286 \text{ mm}$$

Brennweite der Pupillenwabe:

$$f^{pw} = 700 \text{ mm}$$

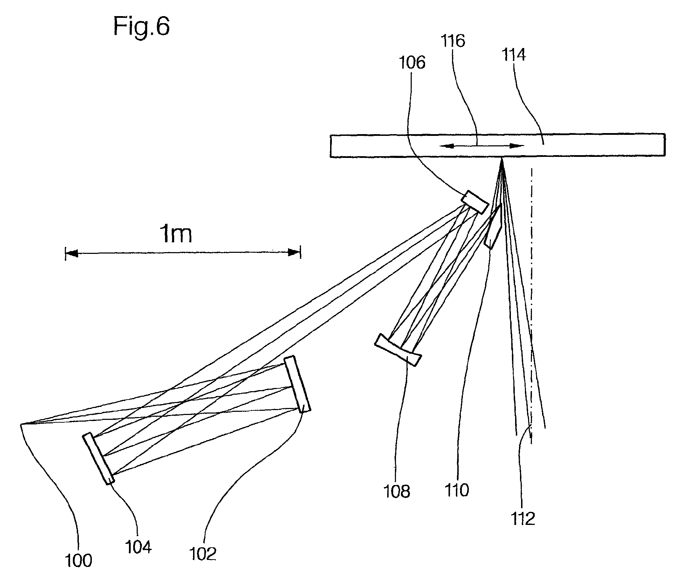

In Figur 6 ist in einer Prinzipansicht ein Beleuchtungssystem, bei dem die Erfindung zur Anwendung kommen kann, gezeigt. Das Beleuchtungssystem umfaßt eine Lichtquelle oder ein Zwischenbild einer Lichtquelle 100. Das von der Lichtquelle bzw. dem Zwischenbild der Lichtquelle 100 ausgesandte Licht, von dem nur drei repräsentative Strahlen gezeichnet sind, trifft auf einen Spiegel 102 mit einer Vielzahl von ersten Rasterelementen, sogenannten Feldwaben. Der Spiegel 102 wird daher auch als Feldwabenspiegel bezeichnet. Die Größen der Feldwaben auf der Feldwabenplatte sind erfindungsgemäß so gewählt, daß sich eine hohe Flächenüberdeckung des von der Lichtquelle ausgeleuchteten Bereiches ergibt und nur wenig Leistung der Lichtquelle verloren geht. Die zweiten Rasterelemente, die sogenannten Pupillenwaben des zweiten optischen Elementes 104, weisen anamorphotische Wirkung auf, welche die unterschiedliche Größen der Feldwaben kompensieren. Die dem zweiten optischen Element mit Rasterelementen 104 riachgeordneten optische Elemente 106, 108 und 110 dienen im wesentlichen dazu, das Feld in der Retikelebene 114 zu formen. Das Retikel in der Retikelebene ist eine Reflexionsmaske. Das Retikel ist in dem als Scanning-System ausgelegten EUV-Projektionssystem in die eingezeichnete Richtung 116 verfahrbar.

Mit Hilfe des in Figur 6 gezeigten Beleuchtungssystem wird die Austrittspupille 112 des Beleuchtungssystems weitgehend homogen ausgeleuchtet. Die Austrittspupille 112 fällt mit der Eintrittspupille eines nachfolgenden Projektionsobjektives zusammen. Ein derartiges Projektionsobjektiv, beispielsweise mit sechs Spiegeln ist in der US-Patentanmeldung 09/503640 gezeigt, deren Offenbarungsgehalt in vorliegende Anmeldung vollumfänglich mitaufgenommen wird.

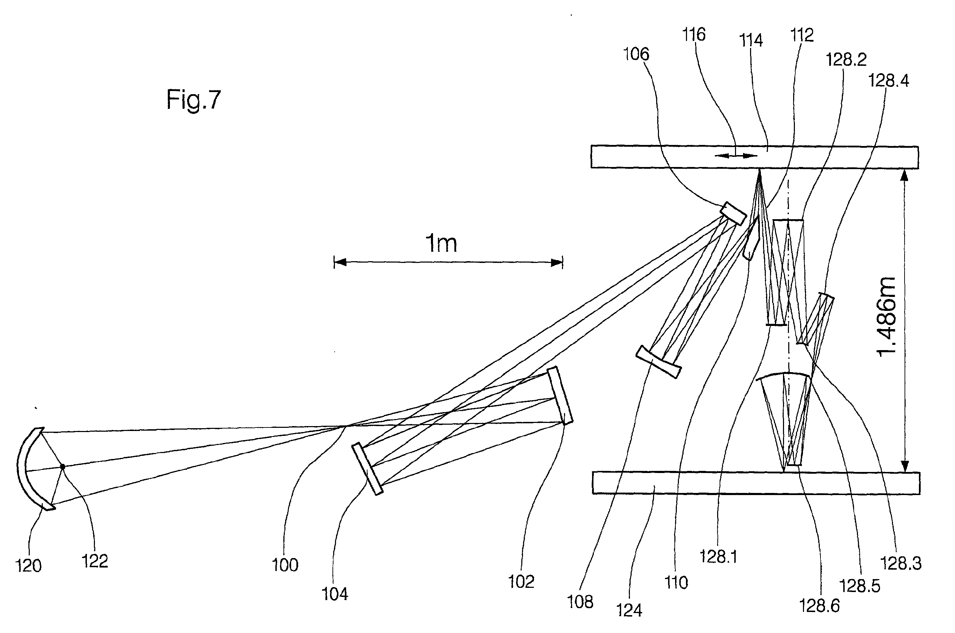

In Figur 7 ist der optische Teil eines Projektionsbelichtungssystems ausgehend von der physikalischen Lichtquelle 122 bis zum zu belichtenden Objekt 124 dargestellt. Gleiche Bauteile wie in Figur 6 sind mit denselben Bezugsziffern belegt. Das System gemäß Figur 7 umfasst die physikalische Lichtquelle 122, einen Kollektor 120 das Beleuchtungssystem aus Fig. 6, ein Projektionsobjektiv 126 beispielsweise mit sechs Spiegeln 128.1, 128.2, 128.3, 128.4, 128.5, 128.6 gemäß der US-Patentanmeldung 09/503640 sowie das zu belichtende Objekt 124.

Mit der Erfindung wird erstmals ein EUV-Beleuchtungssystem angegeben, mit dem die Thermallast auf dem zweiten facettierten Spiegelelement verringert werden kann.

## Patentansprüche

**1.**  Beleuchtungssystem, insbesondere für die Lithographie mit Wellenlängen $\leq$ 193 nm umfassend

1.1 ein erstes optisches Element, das in erste Rasterelemente gegliedert ist und in einer ersten Ebene liegt, die durch eine x-Richtung und eine y-Richtung aufgespannt wird, wobei

1.2 Bilder der ersten Rasterelemente in einer Objektebene des Beleuchtungssystems zum überwiegenden Teil zur Deckung kommen und

1.4 die ersten Rasterelemente jeweils eine x- und eine y-Ausdehnung mit einem Seitenaspektverhältnis aufweisen,

**dadurch gekennzeichnet, daß**

1.5 zumindest zwei Rasterelemente ein unterschiedlich großes Seitenaspektverhältnis aufweisen.

**2.**  Beleuchtungssystem nach Anspruch 1,
**dadurch gekennzeichnet, daß**
das Beleuchtungssystem ein zweites optisches Element, das in zweite Rasterelemente gegliedert ist, umfaßt, wobei den ersten Rasterelementen je ein zweites Rasterelement zugeordnet ist und wobei mindestens ein zweites Rasterelement eine anamorphotische optische Wirkung aufweist.

**3.**  Beleuchtungssystem nach Anspruch 2,
**dadurch gekennzeichnet, daß**
in der Objektebene des Beleuchtungssystems ein Feld mit einem Feldaspektverhältnis beleuchtet wird und zumindest ein Teil der zweiten Rasterelemente eine anamorphotische optische Wirkung aufweist, die derart gewählt ist, daß unabhängig vom Aspektverhältnis der ersten Rasterelemente das Aspektverhältnis der Bilder der ersten Rasterelemente in der Objektebene im wesentlichen gleich ist.

**4.**  Beleuchtungssystem nach einem der Ansprüche 1 bis 3,
**dadurch gekennzeichnet, daß** mindestens eines der zumindest zwei ersten Rasterelemente mit unterschiedlich großem Seitenaspektverhältnis eine anamorphotische optische Wirkung aufweisen.

**5.**  Beleuchtungssystem nach einem der Ansprüche 1 bis 3,
**dadurch gekennzeichnet, daß**
die zumindest zwei ersten Rasterelemente mit unterscheidlich großem Seitenaspektverhältnis eine isotrope optische Wirkung aufweisen.

**6.**  Beleuchtungssystem nach Anspruch 5,
**dadurch gekennzeichnet, daß** die ersten Rasterelemente eine isotrope optische Wirkung aufweisen.

**7.** Beleuchtungssystem nach einem der Ansprüche 1 bis 5,
**dadurch gekennzeichnet, daß**
diejenigen der ersten Rasterelemente, die eine anamorphotische optische Wirkung aufweisen, zylinder- und/oder toroidförmig ausgebildet sind.

**8.** Beleuchtungssystem nach einem der Ansprüche 1 bis 7,
**dadurch gekennzeichnet, daß**
die diejenigen der zweiten Rasterelemente, die eine anamorphotische optische Wirkung aufweisen, zylinder- und/ oder toroidförmig, ausgebildet sind.

**9.** Beleuchtungssystem nach einem der Ansprüche 1 bis 8,
**dadurch gekennzeichnet, daß**
alle ersten Rasterelemente in der ersten Ebene vollständig ausgeleuchtet sind.

**10.** Beleuchtungssystem nach einem der Ansprüche 1 bis 9, **dadurch gekennzeichnet, daß** das Beleuchtungssystem eine Kollektoreinheitumfasst, die die erste Ebene mit den ersten Rasterelementen ausleuchtet.

**11.** Beleuchtungssystem nach einem der Ansprüche 1 bis 10,
**dadurch gekennzeichnet, daß**
das Beleuchtungssystem wenigstens einen Feldspiegel umfaßt.

**12.** Beleuchtungssystem nach Anspruch 11,
**dadurch gekennzeichnet, daß** die zweiten Rasterelemente und der wenigstens eine Feldspiegel die zugeordneten ersten Rasterelemente in die Objektebene des Beleuchtungssystems abbilden.

**13.** Beleuchtungssystem nach einem der Ansprüche 1 bis 12,
**dadurch gekennzeichnet, daß** die ersten Rasterelemente rechteckig sind.

**14.** Beleuchtungssystem nach einem der Ansprüche 1 bis 13, dadaurch **gekennzeichnet**, daß
das zu beleuchtende Feld in der Objektebene des Beleuchtungssystems ein Segment eines Ringfeldes darstellt.

**15.** Projektionsbelichtungsanlage für die Mikrolithographie mit

15.1 einem Beleuchtungssystem gemäß einem der Ansprüche 1 bis 14 mit einer Austrittspupille (112), welche die von einer Lichtquelle (100) erzeugte Strahlung teilweise sammelt und zur Beleuchtung eines Feldes in der Objektebene des Beleuchtungssystems weiterleitet,
15.2 einer strukturtragenden Maske, die in der Objektebene (114) des Beleuchtungssystems liegt;
15.3 einer Projektionseinrichtung, insbesondere einem Projektionsobjektiv (126) mit einer Eintrittspupille, die mit der Austrittspupille (112) des Beleuchtungssystems zusammenfällt, wobei dieses Projektionsobjektiv den beleuchteten Teil der strukturtragenden Maske in ein Bildfeld der Projektionseinrichtung abbildet
15.4 ein lichtsensitives Substrat (124), das in der Ebene des Bildfeldes der Projektionseinrichtung liegt.

**16.** Verfahren zur Herstellung von mikroelektronischen Bauteilen, insbesondere Halbleiterchips mit einer Projektionsbelichtungsanlage gemäß Anspruch 15.

Fig.1

Fig.2

Fig.3

Fig.4

Fig.5

Fig.6

1m

Fig.7